# EUROPEAN PATENT APPLICATION

(11) **EP 4 742 862 A1**
(43) Date of publication of application: **13.05.2026**
(21) Application number: 24849510.3
(22) Date of filing: 26.07.2024
(51) Int. Cl.: H10F 77/12

(54) **PEROVSKITE SOLAR CELL**

(30) Priority: 28.07.2023 KR 20230098701
(71) Applicant: Hanwha Solutions Corporation, Jung-gu Seoul 04541 (KR)
(72) Inventor: KIM, Jun Young, Seoul 04541 (KR); HAN, Sung Hoon, Seoul 04541 (KR); CHOI, In Taek, Seoul 04541 (KR); KIM, Myoung, Seoul 04541 (KR); YUN, Da Eun, Seoul 04541 (KR)
(74) Representative: Mooser, Sebastian Thomas
(86) International application number: PCT/KR2024/010930
(87) International publication number: WO 2025/028941

(57) **Abstract**

An embodiment of the disclosure provides a perovskite solar cell comprising: a lower electrode; a hole transport layer formed on the lower electrode; a perovskite layer formed on the hole transport layer; a passivation layer formed on the perovskite layer; an electron transport layer formed on the passivation layer; and an upper electrode formed on the electron transport layer, wherein the passivation layer includes a halide organic material.

## Description

### Technical Field

The disclosure relates to a perovskite solar cell.

### Background Art

Perovskite solar cells are solar cell devices that use a material with a perovskite structure as a light absorber. They have most of the characteristics required for next-generation solar cells, such as high photoelectric conversion efficiency, low manufacturing cost, and the ability to be processed at low temperature and through low-cost solution processes, and are thus attracting attention as next-generation solar cells that will replace silicon solar cells.

Perovskite solar cells develop various defects on a surface exposed to the outside during the thin film formation process. In the ABX₃ structure, organic substances corresponding to A and halides corresponding to X escape from the ABX₃ structure due to factors such as light, heat, pressure, electric field, and magnetic field, thereby forming defects such as vacancies and interstitials. Additionally, in existing methods, there may be cases where the conduction band energy level of the perovskite light-absorbing layer is lower than the conduction band energy level of the electron transport layer. In this case, there is a problem in that an additional energy-level adjustment layer must be inserted between the two layers to match the conduction band energy levels of the two layers.

### Disclosure

### Technical Problem

The disclosure can provide a perovskite solar cell including a passivation layer containing a halide organic material.

### Solution to Problem

In one aspect, the disclosure provides a perovskite solar cell including: a lower electrode; a hole transport layer formed on the lower electrode; a perovskite layer formed on the hole transport layer; a passivation layer formed on the perovskite layer; an electron transport layer formed on the passivation layer; and an upper electrode formed on the electron transport layer, wherein the passivation layer includes a compound of Formula 1: 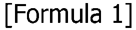 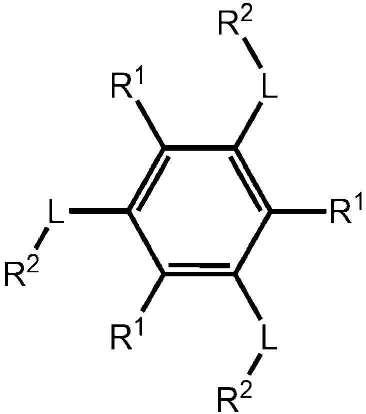 wherein, in Formula 1, R¹ is hydrogen or C₁₋₁₀ alkyl, R² is F, Cl, Br, or I, and L is hydrogen or C₁₋₁₀ alkylene.

In an embodiment of the disclosure, R¹ may be hydrogen or C₁₋₅ alkyl, R² may be Br, and L may be hydrogen or C₁₋₅ alkylene.

In an embodiment of the disclosure, the concentration of the compound of Formula 1 in the passivation layer may be 0.1 to 1 mM.

In an embodiment of the disclosure, the lower electrode and the upper electrode may each be a transparent electrode or a metal electrode.

In an embodiment of the disclosure, the transparent electrode may include ITO, IZO, AZO, or FTO, and the metal electrode may include Ag, Au, Al, Cu, SnPb, SnAgBi, or SnAgCu.

In an embodiment of the disclosure, the hole transport layer may include a material selected from the group consisting of Spiro-OMeTAD, PEDOT:PSS, G-PEDOT, PANI:PSS, PANI:CSA, PDBT, P3HT, PCPDTBT, PCDTBT, PTAA, 2PACz, Me-4PACz, MoO₃, V₂O₅, NiO, WO₃, CuI, CuSCN, and combinations thereof.

In an embodiment of the disclosure, the perovskite layer may include a perovskite material of Formula 2:

[Formula 2] ABX₃

wherein, in Formula 2, A is an alkali metal or a substituted or unsubstituted C₁₋₂₅ alkyl group; when A is substituted, a substituent thereof is an amino group, a hydroxyl group, a cyano group, a halogen group, a nitro group or a methoxy group; B includes a cation of metal selected from the group consisting of Pb, Sn, Ge, Cu, Ni, Co, Fe, Mn, Cr, Pd, Cd, Yb, and combinations thereof, and X includes a halide anion or a chalcogenide anion.

In an embodiment of the disclosure, the electron transport layer may include a material selected from the group consisting of BaSnO₃, TiO₂, ZrO, Al₂O₃, SnO₂, ZnO, WO₃, NbOH, Nb₂O₅, TiSrO₃, and combinations thereof.

In one embodiment of the disclosure, the perovskite solar cell may further include a lower solar cell below the lower electrode.

In an embodiment of the disclosure, the lower solar cell may be a polycrystalline silicon solar cell, a crystalline silicon solar cell, a perovskite solar cell, a GaAs solar cell, a CdTe solar cell, a CIGS solar cell, a CZTS solar cell, an organic solar cell, a dye-sensitized solar cell, or a group III-V compound solar cell.

In an embodiment of the disclosure may further include a buffer layer between the hole transport layer and the perovskite layer, and/or between the electron transport layer and the passivation layer.

In an embodiment of the disclosure, the buffer layer may include at least one of LiF, PEAI, PEABr, 4F-PEAI, octylammonium iodide, oleylamine, 2PACz, 4PACz, Me-4PACz, and MeO-2PACz.

In an embodiment of the disclosure, the work function of the perovskite layer may be 5 eV or less.

In an embodiment of the disclosure, the open-circuit voltage of the perovskite solar cell may be 1.000 V or more.

In another aspect, the disclosure provides a method of manufacturing a perovskite solar cell, including: preparing a lower electrode; forming a hole transport layer on the lower electrode; forming a perovskite layer on the hole transport layer; forming a passivation layer on the perovskite layer; forming an electron transport layer on the passivation layer; and forming an upper electrode on the electron transport layer, wherein the passivation layer includes the compound of Formula 1.

### Advantageous Effects of Invention

The perovskite solar cell according to the disclosure introduces a halide organic layer to control surface defects of the perovskite solar cell, thereby suppressing electron-hole recombination caused by the defects. As a result, this can improve the open-circuit voltage and stability of the perovskite solar cell. In addition, by lowering a work function of the perovskite to impart n-type characteristics thereto, a difference in conduction-band energy level between the electron transport layer and the perovskite layer can be reduced, thereby improving the open-circuit voltage.

### Brief Description of Drawings

FIG. 1 is a cross-sectional view schematically illustrating a perovskite solar cell according to an embodiment of the disclosure.
FIG. 2 is a cross-sectional view schematically illustrating a perovskite solar cell according to another embodiment of the disclosure.
FIG. 3 is a flowchart illustrating a method of manufacturing a perovskite solar cell according to an embodiment of the disclosure.
FIG. 4 illustrates results of X-ray photoelectron spectroscopy (XPS) analysis of a perovskite layer and a passivation layer according to an embodiment of the disclosure.

### <List of Reference Numerals for Major Elements>

1, 1': Perovskite solar cell 10: Upper electrode
20: Electron transport layer 30: Passivation layer
40: Perovskite layer 50: Hole transport layer
60: Lower electrode 70: Lower solar cell

### Best Mode for Carrying out the Invention

An embodiment of the disclosure provides a perovskite solar cell including: a lower electrode; a hole transport layer formed on the lower electrode; a perovskite layer formed on the hole transport layer; a passivation layer formed on the perovskite layer; an electron transport layer formed on the passivation layer; and an upper electrode formed on the electron transport layer, wherein the passivation layer includes a compound of Formula 1:

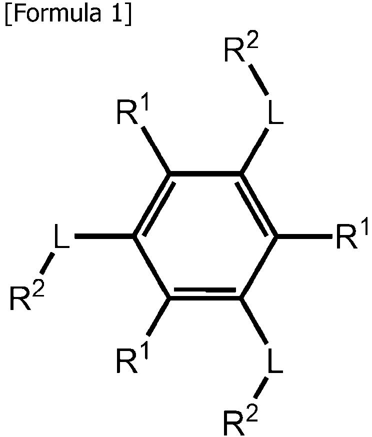

wherein, in Formula 1, R¹ is hydrogen or C₁₋₁₀ alkyl, R² is F, Cl, Br, or I, and L is hydrogen or C₁₋₁₀ alkylene.

Another embodiment of the disclosure provides a method of manufacturing a perovskite solar cell, including: preparing a lower electrode; forming a hole transport layer on the lower electrode; forming a perovskite layer on the hole transport layer; forming a passivation layer on the perovskite layer; forming an electron transport layer on the passivation layer; and forming an upper electrode on the electron transport layer, wherein the passivation layer includes the compound of Formula 1.

### Mode for the Invention

An embodiment of the disclosure is illustrated in the accompanying drawings. However, the inventive concept can be embodied in many other forms and should not be construed as being limited to the embodiments described herein. Rather, these embodiments are provided so that this disclosure will be thorough and complete, and will fully convey the scope of the present inventive idea to those skilled in the art. Identical drawing symbols indicate identical components.

The terminology used herein is for the purpose of describing particular embodiments only and is not intended to limit the invention. As used herein, the singular form is intended to include the plural form unless the context clearly dictates otherwise, including "at least one." "At least one" should not be construed as limiting to a singular form. As used herein, the term "and/or" includes any and all combinations of one or more of the listed items. The terms "comprises" and/or "comprising" as used in the detailed description specify the presence of stated features, regions, integers, steps, operations, components and/or ingredients, but do not preclude the presence or addition of one or more other features, regions, integers, steps, operations, components, ingredients and/or groups thereof.

In this specification, reference to "on" or "above" another object includes not only cases in which one object is directly on the other object, but also cases where another object is interposed therebetween.

Throughout the specification, when a part is said to be "connected (contacted, coupled)" to another part, this includes not only cases where it is directly connected, but also cases where it is indirectly connected with another member interposed therebetween.

Unless otherwise defined, all terms (including technical and scientific terms) used herein have the same meaning as commonly understood by one of ordinary skill in the art to which this disclosure belongs. It will also be understood that terms defined in commonly used dictionaries should be interpreted to have a meaning consistent with their meaning within the context of the relevant art and the present disclosure, and not in an idealized or overly formal sense.

Although specific embodiments have been described, alternatives, modifications, variations, improvements and substantial equivalents, which are presently not anticipated or unforeseen, may occur to the applicant or those skilled in the art. Accordingly, the appended claims, as filed and as amended, are intended to encompass all such alternatives, modifications, variations, improvements and substantial equivalents.

In the disclosure, the terms "alkyl" and "alkylene" may be straight-chain or branched-chain, unless otherwise specified, and the number of carbon atoms is not particularly limited, but may be 1 to 25. In an embodiment, the alkyl group may have 1 to 10 carbon atoms. In another embodiment, the alkyl group may have 1 to 5 carbon atoms. Specific examples of alkyl groups include methyl, ethyl, propyl, n-propyl, isopropyl, butyl, n-butyl, isobutyl, tert-butyl, sec-butyl, 1-methyl-butyl, 1-ethyl-butyl, pentyl, n-pentyl, isopentyl, neopentyl, tert-pentyl, hexyl, n-hexyl, 1-methylpentyl, 2-methylpentyl, 4-methyl-2-pentyl, 3,3-dimethylbutyl, 2-ethylbutyl, heptyl, n-heptyl, 1-methylhexyl, octyl, n-octyl, tert-octyl, 1-methylheptyl, 2-ethylhexyl, 2-propylpentyl, n-nonyl, 2,2-dimethylheptyl, 1-ethyl-propyl, 1,1-dimethyl-propyl, isohexyl, 2-methylpentyl, 4-methylhexyl, 5-methylhexyl, etc., but are not limited to these.

In the following embodiments, the terms first, second, etc. are not used in a limiting sense, but are used for the purpose of distinguishing one component from another.

In the following embodiments, singular expressions include plural expressions unless the context clearly indicates otherwise.

In the drawings, the sizes of components may be exaggerated or reduced for convenience of explanation. For example, the size and thickness of each component shown in the drawing are arbitrarily shown for convenience of explanation, and therefore the disclosure is not necessarily limited to what is shown.

In the following embodiments, the x-axis, y-axis, and z-axis are not limited to the three axes on the orthogonal coordinate system, and can be interpreted in a broad sense that includes them. For example, the x-axis, y-axis, and z-axis may be orthogonal to one another, but may also refer to different directions that are not orthogonal to one another.

In some embodiments, where implementations are otherwise feasible, specific process sequences may be performed in a different order than described. For example, two processes described sequentially may be performed substantially simultaneously, or may proceed in the reverse order from that described.

A perovskite solar cell according to an embodiment of the disclosure may include a lower electrode, a hole transport layer, a perovskite layer, a passivation layer, an electron transport layer, and an upper electrode.

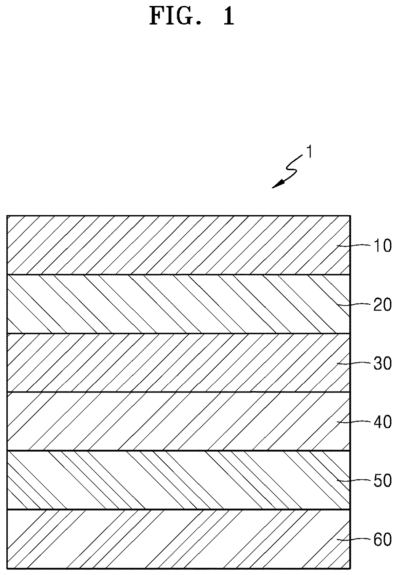

FIG. 1 is a cross-sectional view schematically illustrating a perovskite solar cell according to an embodiment of the disclosure.

According to FIG. 1, a perovskite solar cell 1 may include a lower electrode 60, a hole transport layer 50, a perovskite layer 40, a passivation layer 30, an electron transport layer 20, and an upper electrode 10.

The passivation layer 30 may include a compound of Formula 1 below.

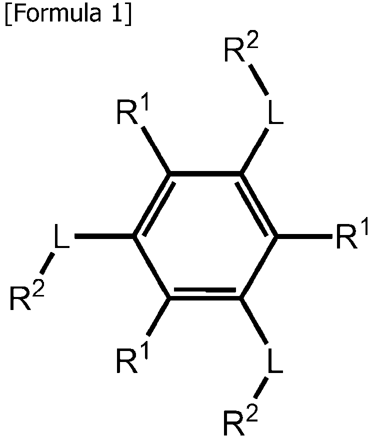

In Formula 1,
R¹ may be hydrogen or C₁₋₁₀ alkyl,
R² may be F, Cl, Br, or I, and
L may be hydrogen or C₁₋₁₀ alkylene.
In some embodiments, R¹ may be hydrogen or C₁₋₅ alkyl,
R² may be Br, and
L may be hydrogen or C₁₋₅ alkylene.

The compound of Formula 1 may be, but is not limited to, 1,3,5-tris(bromomethyl)-2,4,6-triethylbenzene.

The concentration of the compound of Formula 1 in the passivation layer 30 may be 0.1 to 1 mM; 0.1 to 0.8 mM; 0.1 to 0.6 mM; 0.1 to 0.4 mM; 0.2 to 1 mM; 0.2 to 0.8 mM; 0.2 to 0.6 mM; or 0.2 to 0.4 mM.

By including the compound of Formula 1 in the passivation layer 30, surface defects of the perovskite solar cell can be controlled to improve the electrical performance of the device, and an open-circuit voltage can be improved by controlling the energy level of the surface of the perovskite solar cell 1. In addition, stability of the perovskite solar cell 1 can be improved.

The upper electrode 10 and the lower electrode 60 may each be a transparent electrode or a metal electrode. Preferably, at least one of the upper electrode 10 and the lower electrode 60 may be a transparent electrode.

The transparent electrode may be used to facilitate charge collection in a horizontal direction. The upper electrode 10 may be a transparent electrode, and a metal electrode may be patterned and laminated on the transparent electrode. When the lower electrode 60 is connected to a lower solar cell, the lower electrode 60 may preferably be a transparent electrode.

The transparent electrode may include, but is not limited to, ITO, IZO, AZO, or FTO, and the metal electrode may include, but is not limited to, Ag, Au, Al, Cu, SnPb, SnAgBi, or SnAgCu.

The perovskite layer 40 may include a perovskite material of Formula 2 below.

[Formula 2] ABX₃

In Formula 2,
A may be an alkali metal or a substituted or unsubstituted C₁₋₂₅ alkyl group;
when A is substituted, a substituent thereof may be an amino group, a hydroxyl group, a cyano group, a halogen group, a nitro group or a methoxy group;
B may include a cation of metal selected from the group consisting of Pb, Sn, Ge, Cu, Ni, Co, Fe, Mn, Cr, Pd, Cd, Yb, and combinations thereof; and
X may include a halide anion or a chalcogenide anion.

In some embodiments, A may include formamidinium, methylammonium, cesium, rubidium, potassium, sodium, lithium, guanidinium, butylammonium, ethylammonium, or phenethylammonium, and B may include lead, tin, germanium, cadmium, zinc, magnesium, etc. X may include iodide, bromide, chloride, fluoride, thiocyanate, cyanate, selenocyanate, formate, acetate, etc.

The hole transport layer 50, which is a layer that transports holes formed in the perovskite layer 40 to the lower electrode 60 while simultaneously blocking movement of electrons, may include a material selected from the group consisting of Spiro-OMeTAD, PEDOT:PSS, G-PEDOT, PANI:PSS, PANI:CSA, PDBT, P3HT, PCPDTBT, PCDTBT, PTAA, 2PACz, Me-4PACz, MoO₃, V₂O₅, NiO, WO₃, CuI, CuSCN, and combinations thereof.

The electron transport layer 20, which is a layer that transports electrons formed in the perovskite layer 40 to the upper electrode 10 while simultaneously blocking the movement of holes, may include a material selected from the group consisting of BaSnO₃, TiO₂, ZrO, Al₂O₃, SnO₂, ZnO, WO₃, NbOH, Nb₂O₅, TiSrO₃, and combinations thereof.

Meanwhile, a buffer layer may be further included between the hole transport layer 50 and the perovskite layer 40 and/or between the electron transport layer 20 and the passivation layer 30.

The buffer layer, which is for preventing interface defects and improving transport capability, may include at least one of LiF, PEAI, PEABr, 4F-PEAI, octylammonium iodide, oleylamine, 2PACz, 4PACz, Me-4PACz, and MeO-2PACz.

A perovskite solar cell according to another embodiment of the disclosure may further include a lower solar cell.

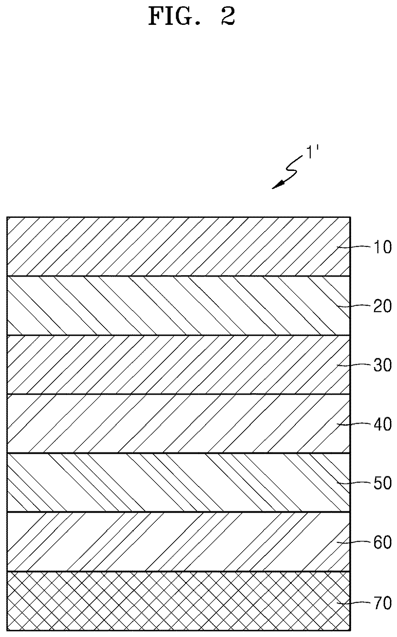

FIG. 2 is a cross-sectional view schematically illustrating a perovskite solar cell further including a lower solar cell according to an embodiment of the disclosure.

Referring to FIG. 2, a perovskite solar cell 1' may further include a lower solar cell 70 provided below the lower electrode 60.

The lower solar cell 70 may be, but is not limited to, a polycrystalline silicon solar cell, a crystalline silicon solar cell, a perovskite solar cell, a GaAs solar cell, a CdTe solar cell, a CIGS solar cell, a CZTS solar cell, an organic solar cell, a dye-sensitized solar cell, or a group III-V compound solar cell.

When the lower solar cell 70 is included below the lower electrode 60, the lower electrode 60 may serve as a recombination layer that induces recombination of electrons and holes generated in the lower solar cell 70 and an upper perovskite solar cell. Therefore, in this case, the lower electrode 60 may preferably be a transparent electrode.

The hole transport layer 50, perovskite layer 40, passivation layer 30, electron transport layer 20, and upper electrode 10 may be identical to or modified from those described in the above embodiment, and thus, detailed descriptions thereof will be omitted.

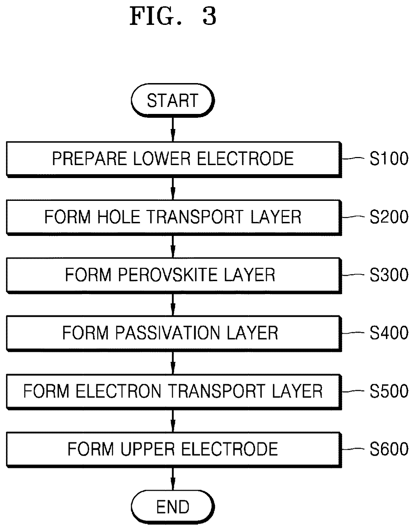

FIG. 3 is a flowchart illustrating a method of manufacturing a perovskite solar cell according to an embodiment of the disclosure.

The disclosure provides a method of manufacturing a perovskite solar cell, including: preparing a lower electrode (S100); forming a hole transport layer (S200); forming a perovskite layer (S300): forming a passivation layer (S400); forming an electron transport layer (S500); and forming an upper electrode (S600).

In another embodiment of the disclosure, the method may further include forming a buffer layer between forming the hole transport layer (S200) and forming the perovskite layer (S300), and/or between forming the passivation layer (S400) and forming the electron transport layer (S500).

The lower electrode, hole transport layer, perovskite layer, passivation layer, electron transport layer, upper electrode, and buffer layer may be identical to or modified from those described in the above embodiments, and thus, detailed descriptions thereof will be omitted.

Hereinafter, the disclosure will be described in detail with reference to experimental examples.

However, the experimental examples described below are merely specific examples illustrating one aspect of the disclosure, and the disclosure is not limited thereto.

### <Experimental Example 1> Ultraviolet Photoelectron Spectroscopy (UPS)

According to the disclosure, UPS was performed on perovskite layers (Examples) including a passivation layer and a perovskite layer (Control Group) not including a passivation layer. The experimental results are shown in Table 1 below.

**[Table 1]**

| | Work Function (eV) | Valence Band Maximum (eV) | Ionization Energy (eV) |
|---|---|---|---|
| Control Group (Perovskite Layer) | 5.35 | 0.67 | 6.02 |
| Example 1 (TBTB 0.3 mM) | 4.87 | 0.99 | 5.86 |
| Example 2 (TBTB 0.5 mM) | 4.71 | 1.13 | 5.84 |
| Example 3 (TBTB 0.7 mM) | 4.84 | 0.96 | 5.80 |

Referring to Table 1, it can be seen that, in the case of the perovskite layer including the passivation layer, the work function is reduced compared to the control, and the energy level is adjusted to be closer to an n-type form.

### <Experimental Example 2> X-ray Photoelectron Spectroscopy (XPS)

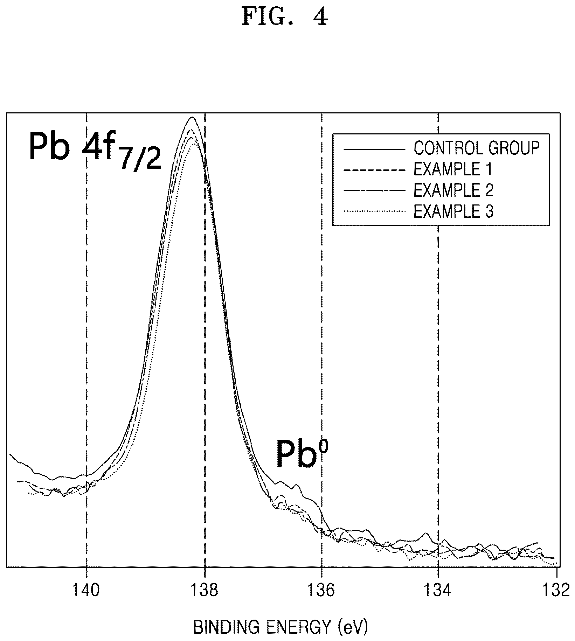

XPS was performed on the control group of Experimental Example 1 and Examples 1 to 3, and the experimental results are shown in FIG. 4.

Referring to FIG. 4, in the case of Examples 1 to 3 including a passivation layer, it can be seen that the peak corresponding to Pb⁰ is reduced compared to the control group. Due to the low work function of the passivation layer, a conduction-band level of an adjacent electron transport layer is relatively lowered, which is expected to facilitate extraction of electrons generated in a light-absorbing layer.

### <Experimental Example 3> Evaluation of Open-Circuit Voltage and Efficiency of Solar Cells

The open-circuit voltage, short-circuit current, fill factor, and efficiency were evaluated for the control group of Experimental Example 1 and perovskite solar cells including Examples 1 to 3. A total of five evaluations were conducted, and the experimental results are shown in Table 2 below.

**[Table 2]**

| | | Open-Circuit Voltage (V) | Short-Circuit Current (mA/cm²) | Fill Factor (%) | Efficiency (%) |
|---|---|---|---|---|---|
| Control Group (Perovskite Layer) | Best | 0.981 | 19.31 | 74.66 | 14.14 |
| | Average | 1.007 | 18.64 | 72.88 | 13.68 |
| Example 1 (TBTB 0.3mM) | Best | 1.053 | 18.99 | 71.74 | 14.35 |
| | Average | 1.050 | 18.68 | 70.11 | 13.76 |
| Example 2 (TBTB 0.5mM) | Best | 1.061 | 18.51 | 67.96 | 13.34 |
| | Average | 1.053 | 18.29 | 67.22 | 12.95 |
| Example 3 (TBTB 0.7mM) | Best | 1.053 | 18.23 | 66.71 | 12.80 |
| | Average | 1.053 | 18.13 | 65.41 | 12.49 |

Referring to Table 2, it can be seen that the open-circuit voltage increased in all solar cells including the examples compared to the control group. In particular, the solar cell including Example 1 exhibited increased peak efficiency and average efficiency due to an increase in open-circuit voltage.

The foregoing description of the disclosure is provided for illustrative purposes only, and a person having ordinary skill in the art to which the disclosure pertains will understand that the disclosure can be easily modified into other specific forms without departing from the technical idea or essential characteristics of the disclosure. Therefore, it should be understood that the embodiments described above are illustrative in all respects and not limiting. For example, each component described as a single entity may be implemented in a distributed manner, and likewise, components described as distributed may be implemented in a combined manner.

The scope of the disclosure is indicated by the claims described below, and all changes or modifications derived from the meaning and scope of the claims and their equivalents should be construed as being included in the scope of the disclosure.

## Claims

1. A perovskite solar cell comprising:
a lower electrode;
a hole transport layer formed on the lower electrode;
a perovskite layer formed on the hole transport layer;
a passivation layer formed on the perovskite layer;
an electron transport layer formed on the passivation layer; and
an upper electrode formed on the electron transport layer,
wherein the passivation layer includes a compound represented by Formula 1: 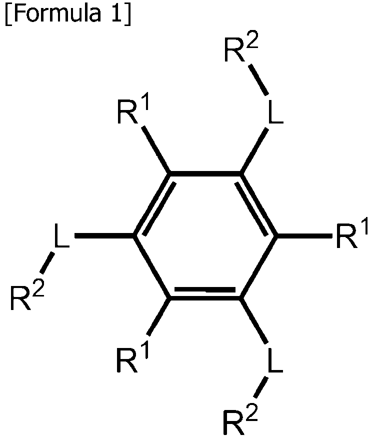
wherein, in Formula 1,
R¹ is hydrogen or C₁₋₁₀ alkyl;
R² is F, Cl, Br, or I; and
L is hydrogen or C₁₋₁₀ alkylene.

2. The perovskite solar cell of claim 1, wherein
R¹ is hydrogen or C₁₋₅ alkyl;
R² is Br; and
L is hydrogen or C₁₋₅ alkylene.

3. The perovskite solar cell of claim 1, wherein
a concentration of the compound of Formula 1 in the passivation layer is 0.1 to 1 mM.

4. The perovskite solar cell of claim 1, wherein
the lower electrode and the upper electrode are each a trans parent electrode or a metal electrode.

5. The perovskite solar cell of claim 4, wherein
the transparent electrode includes ITO, IZO, AZO, or FTO, and
the metal electrode includes Ag, Au, Al, Cu, SnPb, SnAgBi, or SnAgCu.

6. The perovskite solar cell of claim 1, wherein
the hole transport layer includes a material selected from the group consisting of Spiro-OMeTAD, PEDOT:PSS, G-PEDOT, PANI:PSS, PANI:CSA, PDBT, P3HT, PCPDTBT, PCDTBT, PTAA, 2PACz, Me-4PACz, MoO₃, V₂O₅, NiO, WO₃, CuI, CuSCN, and combinations thereof.

7. The perovskite solar cell of claim 1, wherein
the perovskite layer includes a perovskite material of Formula 2:
[Formula 2] ABX₃
wherein, in Formula 2,
A is an alkali metal or a substituted or unsubstituted C₁₋₂₅ alkyl group;
when A is substituted, a substituent thereof is an amino group, a hydroxyl group, a cyano group, a halogen group, a nitro group or a methoxy group;
B includes a cation of metal selected from the group consisting of Pb, Sn, Ge, Cu, Ni, Co, Fe, Mn, Cr, Pd, Cd, Yb, and combinations thereof; and
X includes a halide anion or a chalcogenide anion.

8. The perovskite solar cell of claim 1, wherein
the electron transport layer includes a material selected from the group consisting of BaSnO₃, TiO₂, ZrO, Al₂O₃, SnO₂, ZnO, WO₃, NbOH, Nb₂O₅, TiSrO₃, and combinations thereof.

9. The perovskite solar cell of claim 1, further comprising:
a lower solar cell below the lower electrode.

10. The perovskite solar cell of claim 9, wherein
the lower solar cell is a polycrystalline silicon solar cell, a crystalline silicon solar cell, a perovskite solar cell, a GaAs solar cell, a CdTe solar cell, a CIGS solar cell, a CZTS solar cell, an organic solar cell, a dye-sensitized solar cell, or a group III-V compound solar cell.

11. The perovskite solar cell of claim 1 or 9, further comprising:
a buffer layer between the hole transport layer and
the perovskite layer and/or between at least one of the electron transport layer and the passivation layer.

12. The perovskite solar cell of claim 11, wherein
the buffer layer includes at least one of LiF, PEAI, PEABr, 4F-PEAI, octylammonium iodide, oleylamine, 2PACz, 4PACz, Me-4PACz, and MeO-2PACz.

13. The perovskite solar cell of claim 1, wherein
a work function of the perovskite layer is 5 eV or less.

14. The perovskite solar cell of claim 1, wherein
the perovskite solar cell has an open-circuit voltage of 1.000 V or more.

15. A method of manufacturing a perovskite solar cell, the method comprising:
preparing a lower electrode;
forming a hole transport layer on the lower electrode;
forming a perovskite layer on the hole transport layer;
forming a passivation layer on the perovskite layer;
forming an electron transport layer on the passivation layer; and
forming an upper electrode on the electron transport layer,
wherein the passivation layer comprises the compound of claim 1.
